# EUROPEAN PATENT SPECIFICATION

(11) **EP 0 339 586 B1**
(45) Date of publication and mention of the grant of the patent: **11.10.1995**
(21) Application number: 89107493.2
(22) Date of filing: 25.04.1989
(51) Int. Cl.: H01L 29/41, H01L 27/10, H01L 51/00

(54) **Semiconductor device having improved gate capacitance and manufacturing method therefor**
Halbleiter-Bauelement mit verbesserter Gate-Kapazität und dessen Herstellungsverfahren
Dispositif semiconducteur ayant une capacité de grille améliorée et procédé pour sa fabrication

(30) Priority: 25.04.1988 JP 101811/88
(43) Date of publication of application: 02.11.1989
(73) Proprietor: NEC CORPORATION, Tokyo (JP)
(72) Inventor: Kitaoka, Nobuyasu, Minato-ku Tokyo (JP)
(74) Representative: Glawe, Delfs, Moll & Partner

(56) References cited:
- EP-A- 0 002 165
- EP-A- 0 187 278
- EP-A- 0 197 738
- DE-A- 2 943 150
- DE-A- 3 131 875
- GB-A- 2 077 993
- PATENT ABSTRACTS OF JAPAN vol. 10, no. 347 (E-457)(2403), 21 November 1986; & JP-A-61 150 376

## Description

The present invention relates to a semiconductor device and a manufacturing method therefor, and more particularly to a MOS transistor with a structure in which an enlarged gate capacitance is incorporated with a gate electrode, and a manufacturing method therefor.

### Description of the Related Art:

Among static random access memories (SRAMs) widely in use as a semiconductor memory device, there are some which store specified information by employing a flip-flop circuit structure formed with MOS transistors.

Generally, in constructing the flip-flop circuit with MOS transistors, a sufficient quantity of electrical charge according to the information to be stored is secured in a stray capacitance of the gate electrodes of the MOS transistors. The gate stray capacitances are made relatively large in order to preclude inversion of the stored information even when a part of the charge held is dissipated due to incidence of ionizing radiation such as α rays.

In order to realize such a construction, the gate capacitance of the MOS transistor has been made large in the past by forming an electrically conductive layer on the gate electrode via an insulating film, and grounding the conductive layer. In addition, in a MOS transistor with lightly doped drain (LDD) structure intended to shorten the channel length, the gate electrode has been given a structure with side walls in order to facilitate the formation of diffused source and drain regions. Further, for the gate electrode, use has been made of a single layer of polycrystalline silicon or a double-layer (polycide) structure in which a refractory metal (high-melting point metal) silicide layer is formed on top of a polycrystalline silicon layer to reduce the resistance of the gate electrode. However, in the case of a gate electrode with a single layer of polycrystalline silicon, wiring resistance tends to be large compared with the case of polycide structure so that it has been difficult to operate the circuit at high speed. Further, in the case of a gate electrode with polycide structure, an anisotropic dry etching for forming side walls evaporates silicon atoms in the upper refractory metal silicide to break the bonding between the obtained refractory metal rich silicide and the silicon in the following annealing process. More specifically, when an insulating film is formed later by thermally oxidizing the refractory metal-rich silicide layer to form the additional gate capacitance, there arises a drawback that the refractory metal-rich silicide layer is separated from polycrystalline silicon layer due to a difference in thermal expansions because it is in a metal-rich state as a result of the dry etching. This separation takes place all over the boundary between the refractory metal silicide layer and the polycrystalline silicon layer. It is conspicuous especially when the refractory metal silicide layer is formed thin. To prevent this separation, formation of the insulating film for the additional gate capacitance has to be carried out by a CVD method at low temperature. However, the low temperature oxidation tends to generate many pinholes in a CVD insulating film, which made it necessary to form the film with large thickness, resulting in a small additional capacitance. For these reasons, a large capacitance could not be added with the case of using a thermally oxidized film.

In the prior art SRAM, the gate electrode of a MOS transistor was formed with the polycide structure to increase the speed of circuit operation by reducing the wiring resistance. This requirement took preference of the enlargement of gate capacitance, causing a reduced resistance to the soft errors.

Semiconductor devices according to the preamble of claim 1 are disclosed in EP-A-0 002 165 and GB-A-2 077 993, respectively. In this devices a MOSFET having a gate electrode of reduced resistance is provided by a multi-layer structure of the gate electrode consisting of a first polysilicon film, a silicide film and a second polysilicon film. Any additional gate capacitance is not provided in these devices.

EP-A-0 197 738 discloses an LDDMOS transistor, and EP-A-0 187 278 shows an MOS transistor including floating and control gates.

DE-A-2943150 discloses further semiconductor devices.

It is an object of the invention to provide a semiconductor device including an MOS transistor with small gate resistance and large gate capacitance and which is capable of high speed operation, and to provide a method of manufacturing the same.

This object is achieved by a semiconductor MOS memory device as defined in claim 1 and by a method for manufacturing the device as defined in claim 2.

By giving in this manner a laminated structure of polycrystalline silicon layers and a refractory metal silicide layer to the gate electrode, it is possible to reduce the gate resistance and to form a thin and satisfactory insulating film by thermal oxidation without receiving damages from an anisotropic dry etching, since the topmost layer of the gate electrode is made of a polycrystalline silicon layer, while maintaining the mutual adhesive force strong, and to realize a large gate capacitance.

As a result, in the semiconductor device in accordance with the present invention, it is possible to realize simultaneously an increase in the speed of circuit operation and a high resistance to soft errors in an SRAM, and to provide an SRAM with high reliability.

The aforementioned objects, constitution and advantages of the present invention will become more apparent from the following detailed description taken in conjunction with the accompanying drawings, wherein:
Fig. 1 is a circuit diagram illustrating a static random access memory employing MOS transistors;
Fig. 2 is a sectional diagram of a conventional MOS transistor having a gate electrode consisting of a single layer of polycrystalline silicon;
Fig. 3 is a sectional diagram of a conventional MOS transistor having a gate electrode consisting of a two-layer structure of polycrystalline silicon layer and a refractory metal silicide layer;
Fig. 4 is a sectional diagram of a first embodiment of the MOS transistor according to the present invention; and
Fig. 5 is a sectional diagram of a second embodiment of the MOS transistor according to the present invention.

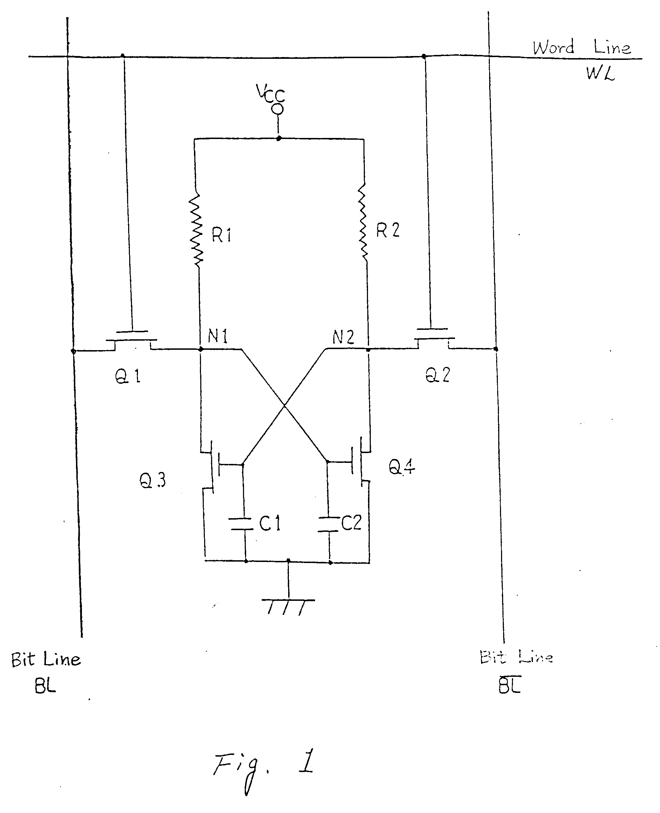

In Fig. 1, is shown a circuit diagram for the case that a MOS transistor is applied to a static random access memory. A flip-flop circuit is formed between bit lines BL and B̅L̅, and the connection between the bit lines BL and B̅L̅ and nodes N1 and N2 are controlled by MOS transistors Q1 and Q2. The gates of the MOS transistors Q1 and Q2 are connected commonly to a word line WL. The flip-flop circuit is formed by connecting in parallel a series circuit consisting of a resistor R1 and a MOS transistor Q3 and a series circuit consisting of a resistor R2 and a MOS transistor Q4 between a power supply potential Vcc and a ground potential GND. The node N1 connecting the resistor R1 and the MOS transistor Q3 is connected via the MOS transistor Q1 to the bit line BL and is also connected to the gate of the MOS transistor Q4. Similarly, the connecting node N2 between the resistor R2 and the MOS transistor Q4 is connected via the MOS transistor Q2 to the bit line B̅L̅ and is also connected to the gate of the MOS transistor Q3. Further, at the respective gates of the MOS transistors Q3 and Q4, there are formed additional capacitors C1 and C2 by using stray capacitors of wiring layers.

As in the above, in an SRAM, after a high level voltage ("1") is applied to the bit line BL and a low level voltage ("0") to the bit line B̅L̅, the high level "1" and the low level "0" are transmitted to the nodes N1 and N2, respectively, by turning on the MOS transistors Q1 and Q2. This causes in the flip-flop circuit to turn off the MOS transistor Q3 and to turn on the MOS transistor Q4. As a result, a high level of the node N1 and a low level of the node N2 are established. At this time, electric charge is accumulated in the added capacitor C2 on the high-level side, so that the two added capacitors C1 and C2 formed on the gates of the transistors Q3 and Q4, respectively, operates to maintain the established gate potentials at the transistors Q3 and Q4.

Now, assume that the capacitances of the added capacitors C1 and C2 are not sufficiently large. Then, if an ionizing radiation (such as γ rays, α rays and electron beams) is incident on an SRAM which is in a state of storing specified information, there will be created electron-positive hole pairs within the gate oxide film of the MOS transistor. Among these pairs generated, the electrons enter the drain regions of the MOS transistors connected to the nodes N1 and N2, by driftinng. At this time, if the node N1 holds the high level, electrons flow to the capacitor C2 through the node N1 to combine with holes stored in the capacitor C2. Therefore, the charges stored in the capacitor C2 are reduced to lower the gate potential of the MOS transistor Q4. As a result, the MOS transistor Q4 turns off and the potential of the node N2 goes to the high level, while the transistor Q3 turns on and the potential of the node N1 goes to the low level. In this way, there will be created an inversion of the stored information.

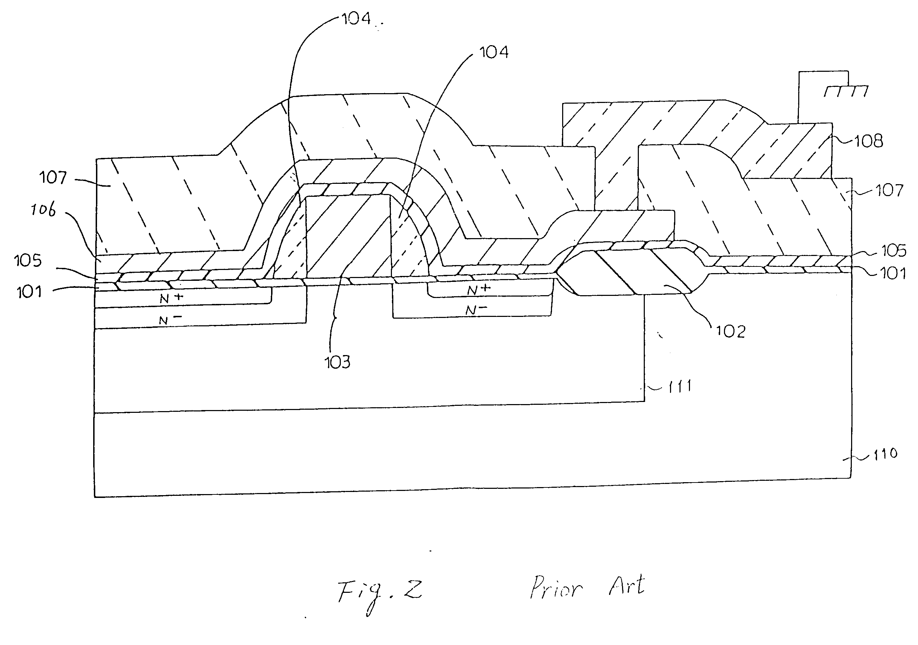

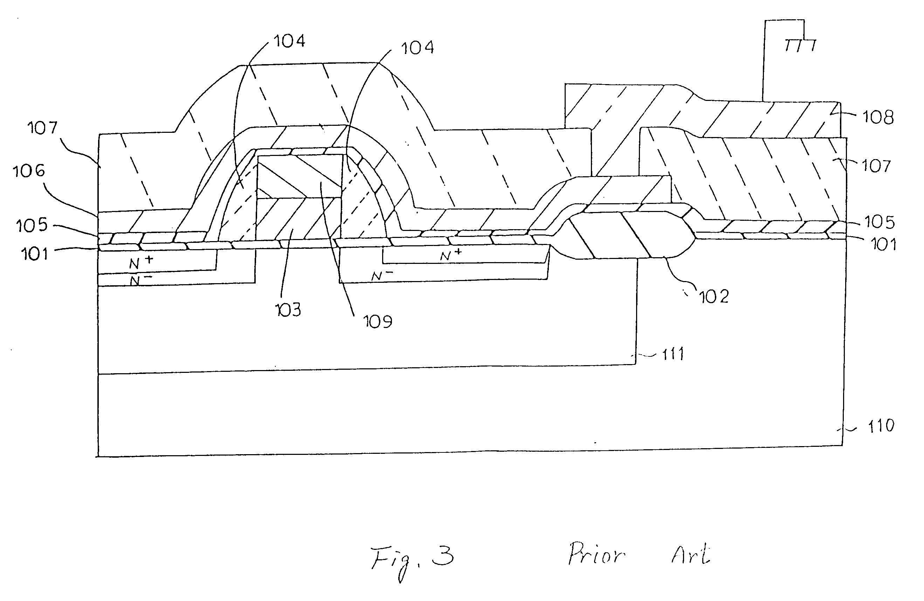

In Fig. 2 and Fig. 3, there are shown sectional diagrams of the conventional MOS transistors having an LDD structure and having an additional capacitance on a gate electrode that are used in SRAMs. As illustrated in Fig. 2, the fundamental structure of such a transistor is as follows. First, a P well (P_{well}) 111 is formed on top of an N-type semiconductor substrate (N_{sub}) 110, and a field oxide film 102 is formed. Then, after forming a gate oxide film 101, a polycrystalline silicon layer 103 is deposited and a gate electrode is formed by subjecting the polycrystalline silicon layer 103 to a lithographic process. With the gate electrode as a mask, ion-implantation of an N-type impurity is carried out to form low concentration impurity regions (N⁻). Next, after depositing a vapor growth oxide film all over the surface, the top surface of the gate electrode is exposed and side walls 104 are formed on side faces of the gate polycrystalline silicon layer 103 by an anisotropic dry etching. In this state, the N-type impurity is ion-implanted again with the gate part as the mask to form high concentration impurity regions (N⁺). Next, a thermal oxide film 105 is formed with a thickness of about 20 nm (200 Å) to 30 nm (300 Å) by thermally oxidizing the surface of the semiconductor substrate including the polycrystalline silicon layer 103 in the top surface of the gate electrode. A wiring polycrystalline silicon layer 106 is deposited on top of the thermal oxide film 105, and is patterned according to a predetermined form using a lithographic process. Subsequently, a vapor growth film 107 is deposited and a contact hole is formed by a lithographic process, and an aluminum wiring 108 is formed. In this manner, a semiconductor device with a structure in which a capacitor is added to the gate electrode of a MOS transistor is obtained.

In a MOS transistor with such a constitution, the gate polycrystalline silicon layer 103 and the wiring polycrystalline silicon layer 106 form a capacitor with the thermal oxide film 105 as a dielectric film. By connecting the aluminum wiring 108 in the upper layer to the ground potential, there is realized the structure consisting of the MOS transistor Q3 and the additional capacitor C1 or the structure consisting of the MOS transistor Q4 and the additional capacitor C2 for the SRAM as shown in Fig. 1. However, in a gate electrode structure consisting of a single layer of polycrystalline silicon, the wiring resistance becomes large leading to a disadvantage in that it is an obstacle to high-speed operation of the circuit.

For this reason, a MOS transistor with the polycide structure as shown in Fig. 3 is being used to suppress the increase in the gate resistance. Namely, increase in the gate resistance is suppressed by replacing the gate polycrystalline silicon layer 103 in Fig. 2 with a two-layer structure obtained by laminating a refractory metal silicide layer 109 such as tungsten silicide on the polycrystalline silicon layer 103.

In the so-called polycide structure of the gate electrode consisting of a lower layer of polycrystalline silicon and an upper layer of refractory metal silicide, the wiring resistance is a number which is one order of magnitude smaller than that of the gate electrode with a single layer of polycrystalline silicon, which enables the fast operation of the circuit. However, the capacitance of the capacitor added to the MOS transistor remains very small compared with that of a gate electrode structure with a single layer of polycrystalline silicon. That is, in forming a vapor growth oxide film all over the surface after formation of the gate electrode with polycide structure, and exposing tungsten silicide in the upper layer of the gate electrode and forming side walls on the side faces of the gate electrode by means of an anisotropic etching, tungsten silicide suffers damages caused by etching, and becomes tungsten-rich. Because of this, if the system is subjected to an ordinary thermal oxidation in this condition, it gives rise to a drawback in which the tungsten-rich silicide layer separates at the respective boundary from the polycrystalline silicon layer in the lower layer and the vapor growth oxide film on the side faces due to the differences in thermal expansions caused by the metal-rich condition of tungsten silicide.

Therefore, in using a gate electrode with polycide structure, formation of the insulating film on tungsten silicide is carried out by a low temperature CVD method obtaining a film of thickness in the range of 200 nm (2000 Å) to 300 nm (3000 Å). Moreover, insulation property of a CVD oxide film is less satisfactory than that of a thermally oxidized film because of pinholes and the like are found in it so that the thickness of the insulating film has to be increased substantially in order to secure the insulating property required as a dielectric film. Therefore, there was a drawback in a MOS transistor having a gate electrode with polycide structure that the value of the capacitance of the capacitor added to the gate electrode is at a very small value and the resistance to the incidence of α rays and the like is accordingly at a low level.

Referring to the accompanying drawings, the present invention will now be described next.

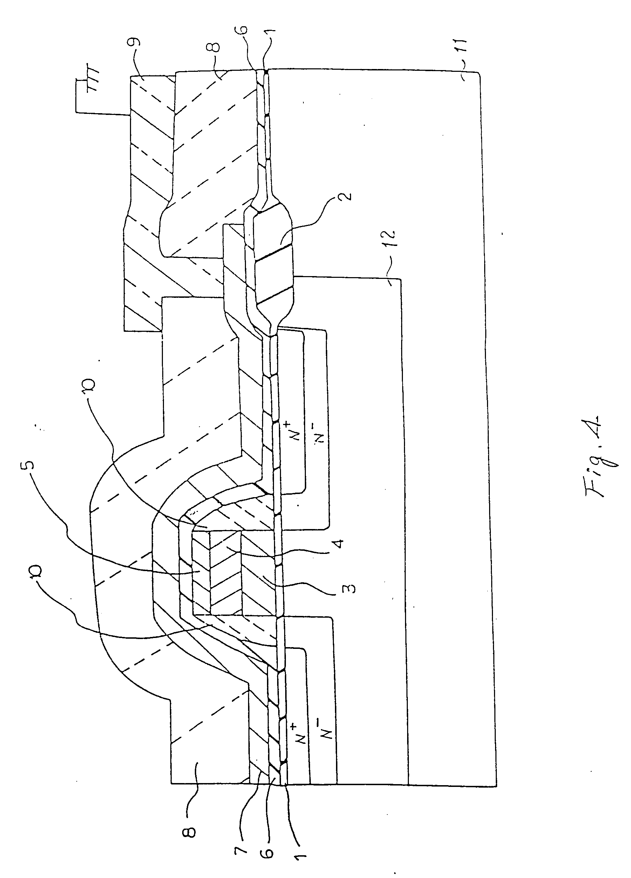

In Fig. 4 which shows a sectional diagram of a first embodiment of the present invention, a gate electrode is shown to have a laminated structure consisting of a lower layer of polycrystalline silicon 3, an intermediate layer of a refractory metal silicide 4 and an upper layer of polycrystalline silicon 5. A P-type well (P_{well}) 12 is formed on an N-type semiconductor substrate (N_{sub}) 11, and a thick field oxide film 2 is formed in accordance with the ordinary element separation method. After forming a gate oxide film 1, 200 nm (2,000 Å) of a polycrystalline silicon layer 3, 200 nm (2,000 Å) of a tungsten silicide layer 4 and 50 nm (500 Å) of a polycrystalline silicon layer 5 are deposited in this order, a gate electrode is formed by subjecting these laminated structure to the lithographic process. Then, N⁻ regions is formed by ion-implantation of an N-type impurity with the gate electrode as the mask. Next, a vapor growth oxide film with a thickness of 200 nm (2,000Å) is deposited, and side walls 10 are formed by an anisotropic dry etching. In this state, N⁺ regions are formed by ion-implanting the N-type impurity again. Then, a thermal oxide film 6 with a thickness of 20 nm (200 Å) is formed on the surface of the semiconductor substrate including the polycrystalline silicon layer 5 in the topmost part of the gate electrode by a thermal oxidation. A wiring polycrystalline silicon layer 7 with a thickness of 200 nm (2,000 Å) is formed on the thermal oxide film 6, and the unwanted portions are removed by the lithographic process. Next, a vapor growth film 8 is deposited with a thickness of 1000 nm (10,000 Å), a contact hole is formed by a lithographic process, and aluminum 9 is deposited with a thickness of 1000 nm (10,000 Å). Following that, aluminum 9 is patterned in a predetermined form, and is grounded. In this manner, there is obtained a semiconductor device in which an additional capacitor is formed between the wiring polycrystalline silicon layer 7 and a gate electrode with a laminated structure consisting of the polycrystalline silicon layers 3 and 5 and the tungsten silicide layer 4 via the thin thermal oxide film 6.

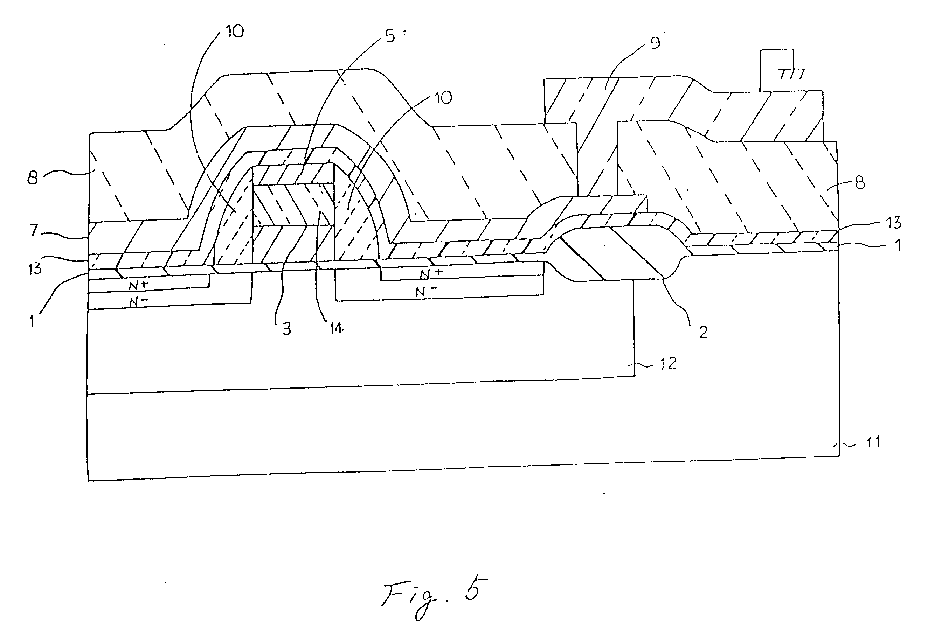

Fig. 5 is a sectional diagram showing a second embodiment of the present invention. In this embodiment, the process until the formation of the gate oxide film 1 is the same as in the first embodiment. Thereafter, 200 nm (2,000 Å) of a polycrystalline silicon layer 3, 200 nm (2,000 Å) of a titanium silicide layer 14 and 50 nm (500 Å) of a polycrystalline silicon layer 5 are deposited in this order, and a gate electrode is formed by subjecting the laminated structure to the lithographic process. Side walls 10 are formed in a manner similar to the first embodiment. Next, a thermal oxide film with a thickness of 10 nm (100 Å) is formed on the surface of the semiconductor substrate including the polycrystalline silicon layer 5 in the topmost part of the gate electrode. A silicon nitride film with a thickness of 20 nm (200 Å) is deposited, a silicon oxide film with a thickness of 2 nm (20 Å) is formed by means of a thermal oxidation on the silicon nitride film, and a triple-layer insulating film 13 is formed.

Next, a wiring polycrystalline silicon layer 7 is deposited with a thickness of 200 nm (2,000 Å), and the unwanted portions are removed by the lithographic process. With steps similar thereafter to those of the first embodiment, the wiring polycrystalline silicon layer is grounded.

With the steps described in the above, a semiconductor device is formed in which a capacitor is formed via a dielectric film consisting of a triple-layer insulating film 13 between the wiring polycrystalline silicon layer 7 and a gate electrode with a laminated structure consisting of the polycrystalline silicon layers 3 and 5 and the titanium silicide layer 14. In this present embodiment, a silicon nitride film is included as the insulating film 13. In the case of equal thickness, the silicon nitride film can achieve twice in capacitance compared with the thermal oxide film. However, pinholes tends to be formed in a single layer of silicon nitride so that an improvement of the film quality can be realized by forming a silicon oxide film in the upper layer. In this case, a decrease in the capacitance can be suppressed by the formation of the silicon nitride film although the film thickness is increased.

The insulating film formed on the gate electrode is not only said triple-layer insulating film 13 consisting of the silicon oxide film, the silicon nitride film and the silicon oxide film, but may be a twice-layer structure consisting of the silicon oxide film and the silicon nitride film, or a laminated structure formed by laminating plural silicon oxide films and silicon nitride films mutually. Furthermore, insulators used as a insulating film on the gate electrode are not only the silicon oxide film and the silicon nitride film, but may be other insulators having high dielectric constant.

Application of the first and second embodiments of the present invention described above to the SRAM in Fig. 1 leads to the values of the capacitances C1 and C2 greater than those of the prior art. With the additional capacitors C1 and C2, data inversion at the storage nodes N1 and N2 due to ionizing radiation such as α rays is suppresed, and the resistance to soft errors can be enhanced.

As described in the foregoing, in accordance with the present invention, the gate electrode is given a laminated structure consisting of a polycrystalline silicon layer and a refractory metal silicide layer, so that it becomes possible the wiring resistance at a low level. Because of this, it becomes possible to increase the operation speed of the circuit.

Furthermore, since the topmost part of the gate electrode is a polycrystalline silicon layer, it is possible to form an oxide film with excellent insulation capability by means of the thermal oxidation while keeping good adhesivity between the layers, and to reduce the thickness of the insulating film. As a result, a capacitor with high capacitance can be formed between the gate electrode and the electrically conductive layer. Therefore, data inversion at the storage nodes due to ionizing radiation such as α rays can be suppressed, giving rise to an effect of enhancing the resistance against soft errors. In accordance with the present invention, effects mentioned above become realizable concurrently.

In the above embodiments, application of the present invention has been described in conjunction with a MOS transistor for SRAM. However, similar effects can also be obtained as long as the circuit has a structure in which a capacitor is connected to the gate part of a MOS transistor, and the capacitor on the circuit can be integrated on the device.

In addition, the embodiments have been described in terms of LDD type MOS transistor. However, the present invention need not be limited to this type alone and similar effects will be obtainable when applied to the ordinary MOS transistor.

## Claims

1. A semiconductor MOS memory device comprising:
source and drain regions, formed on one principal surface of a semiconductor substrate of one conductivity type, with the opposite conductivity type;
a gate oxide film (1) formed on said semiconductor substrate surface between said source and drain regions;
a gate electrode (3, 4, 5; 3, 14, 5) formed on said gate oxide film and consisting of a laminated layer structure of a first polycrystalline silicon layer (3), a refractory metal silicide layer (4, 14) and a topmost layer of a second polycrystalline silicon layer (5) formed on said refractory silicide layer;
an insulating film (6, 13) formed on said second polycrystalline silicon layer in the topmost layer of said gate electrode; and
an electrically conductive layer formed on said insulating film, characterized in that said insulating film on said second polycrystalline silicon layer in the topmost layer of said gate electrode has a laminated structure of a thermal silicon oxide film and a silicon nitride film wherein an additional gate capacitance (C1, C2) is formed by connecting the conductive layer to a reference potential.

2. A method of manufacturing a semiconductor MOS memory device comprising the steps of:
forming a gate oxide film (1) on a surface of a semicondutor substrate of one conductivity type;
forming a first polycrystalline silicon layer (3) on said gate oxide film;
forming a refractory metal silicide layer (4, 14) on said polycrystalline silicon layer;
forming a second polycrystalline silicon layer (5) on said refractory metal silicide layer;
patterning said first and second polycrystalline silicon layers (3, 5) and said refractory metal silicide layer (4, 14) in a predetermined form;
introducing impurities of opposite conductivity type into said semiconductor substrate with said first and second polycrystalline silicon layers and said refractory metal silicide layer that are patterned as a mask;
exposing the surface of said silicon substrate by applying an anistropic etching after forming an oxide film over the surface;
introducing impurities of the opposite conductivity type into said semiconductor substrate with said first and second polycrystalline silicon layers (3, 5) and said refractory metal silicide layer (4, 14) that are patterned and said oxide film left on side faces of said layers as the mask;
forming a thermal oxide film by applying a thermal oxidation to the surface of said second polycrystalline silicon layer (5);
forming in succession a silicon nitride film and a silicon oxide film on said thermal oxide film; and
forming an electrically conductive layer on said silicon oxide film.

## Patentansprüche

1. MOS-Halbleiterspeichervorrichtung mit:
Source- und Drainbereichen, die auf einer Hauptfläche eines Halbleitersubtrats, das einen Leitfähigkeit-Typ aufweist,
mit dem entgegensetzten Leitfähigkeitstyp ausgebildet sind, einem Gateoxidfilm (1), der auf der Halbleitersubstratfläche zwischen den Source- und Drainbereichen ausgebildet ist,
einer Gateelektrode (3, 4, 3; 3, 14, 5), die auf dem Gate-Oxidfilm ausgebildet ist und aus einer geschichteten Schichtstruktur aus einer ersten polykristallinen Siliziumschicht (3), einer Refraktormetall-Silizidschicht (4, 14) und einer obersten Schicht aus einer zweiten polykristallinen Siliziumschicht (5) ausgebildet ist, die auf der Refraktor-Silizidschicht ausgebildet ist,
einem Isolierfilm (6, 13), der auf der zweiten polykristallinen Siliziumschicht in der obersten Schicht der Gateelektrode ausgebildet ist, und
einer elektrisch leitfähigen Schicht, die auf dem Isolierfilm ausgebildet ist,
dadurch **gekennzeichnet**, daß der Isolierfilm auf der zweiten polykristallinen Siliziumschicht in der obersten Schicht der Gateelektrode eine geschichtete Struktur eines thermischen Siliziumoxidfilms und eines Silizium-Nitridfilms aufweist, wobei eine zusätzliche Gatekapazität (C1, C2) durch Verbinden der leitfähigen Schicht mit einem Bezugspotential gebildet wird.

2. Verfahren der Herstellung einer MOS-Halbleiterspeichervorrichtung mit den Schritten:
Ausbilden eines Gateoxidfilms (1) auf der Fläche eines Halbleitersubstrats eines Leitfähigkeitstyps,
Ausbilden einer ersten polykristallinen Siliziumschicht (3) auf dem Gateoxidfilm,
Ausbilden einer Refraktormetall-Silizidschicht (4, 14) auf der polykristallinen Siliziumschicht,
Ausbilden einer zweiten polykristallinen Siliziumschicht (5) auf der Refraktormetall-Silizidschicht,
Strukturieren der ersten und der zweiten polykristallinen Siliziumschicht (3, 5) und der Refraktormetall-Silizidschicht (4, 14) in vorgegebener Form,
Einbringen von Störstoffen des entgegengesetzten Leitfähigkeitstyps in das Halbleitersubstrat, mit der ersten und der zweiten polykristallinen Siliziumschicht und der Refraktormetall-Silizidschicht, die strukturiert sind, als Maske,
Freilegen der Oberfläche des Silizium-Substrats durch Anwenden anisotropen Ätzens nach der Ausbildung eines Oxidfilms über der Fläche,
Einbringen von Störstoffen des entgegengesetzten Leitfähigkeitstyps in das Halbleitersubstrat mit der ersten und der zweiten polykristallinen Siliziumschicht (3, 5) und der Refraktormetall-Silizidschicht (4, 14), die strukturiert sind, und dem Oxidfilm, der auf den Seitenflächen der Schichten belassen wurde, als Maske,
Ausbildung eines thermischen Oxidfilms durch Anwendung einer thermischen Oxidierung an der Oberfläche der zweiten polykristallinen Siliziumschicht (5), Ausbilden eines Siliziumnitridfilms und eines Siliziumoxidfilms in Folge auf dem thermischen Oxidfilm und
Ausbilden einer elektrisch leitfähigen Schicht auf dem Siliziumoxidfilm.

## Revendications

1. Dispositif de mémoire à semi-conducteur MOS comportant:
des régions de source et de drain, formées sur une surface principale d'un substrat semi-conducteur d'un premier type de conductivité, celles-ci ayant une conductivité de type opposé,
un film d'oxyde (1) de grille, formé sur ladite surface du substrat semi-conducteur entre lesdites régions de source et de drain,
une électrode de grille (3, 4, 5; 3, 14, 5) formée sur ledit film d'oxyde de grille et composée d'une structure de couches superposées constituée d'une première couche de silicium polycristallin (3), d'une couche réfractaire (4, 14) de siliciure de métal et d'une couche supérieure extrême constituée d'une seconde couche de silicium polycristallin (5) formée sur ladite couche réfractaire de siliciure,
un film isolant (6, 13) formé sur ladite seconde couche de silicium polycristallin dans la couche supérieure extrême de ladite électrode de grille, et
une couche électriquement conductrice formée sur ledit film isolant,
caractérisé en ce que ledit film isolant formé sur ladite seconde couche de silicium polycristallin dans la couche supérieure extrême de ladite électrode de grille a une structure de couches superposées constituée d'un film d'oxyde thermique de silicium et d'un film de nitrure de silicium, dans laquelle une capacité supplémentaire de grille (C1, C2) est formée en reliant la couche conductrice à un potentiel de référence.

2. Procédé de fabrication d'un dispositif de mémoire à semi-conducteurs MOS, comportant les étapes consistant à:
former un film d'oxyde (1) de grille sur la surface d'un substrat semi-conducteur d'un premier type de conductivité,
former une première couche de silicium polycristallin (3) sur ledit film d'oxyde de grille,
former une couche réfractaire (4, 14) de siliciure de métal sur ladite couche de silicium polycristallin,
former une seconde couche de silicium polycristallin (5) sur ladite couche réfractaire de siliciure de métal,
configurer lesdites première et seconde couches de silicium polycristallin (3, 5) et ladite couche réfractaire (4, 14) de siliciure de métal en une forme prédéterminée,
introduire des impuretés d'une conductivité de type opposé dans ledit substrat semi-conducteur en utilisant comme masque lesdites première et seconde couches de silicium polycristallin et ladite couche réfractaire de siliciure de métal qui sont configurées,
mettre à nu la surface dudit substrat en silicium en appliquant une attaque anisotrope après formation d'un film d'oxyde au-dessus de la surface,
introduire des impuretés d'un type de conductivité opposé dans ledit substrat semi-conducteur en utilisant comme masque lesdites première et seconde couches de silicium polycristallin (3, 5) et ladite couche réfractaire (4, 14) de siliciure de métal, qui sont configurées, et ledit film d'oxyde subsistant sur les faces latérales desdites couches,
former un film d'oxyde thermique en appliquant une oxydation thermique sur la surface de ladite seconde couche de silicium polycristallin (5),
former consécutivement un film de nitrure de silicium et un film d'oxyde de silicium sur ledit film d'oxyde thermique, et
former une couche électriquement conductrice sur ledit film d'oxyde de silicium.
